# EUROPEAN PATENT APPLICATION

(11) **EP 2 378 789 A1**
(43) Date of publication of application: **19.10.2011**
(21) Application number: 10738408.3
(22) Date of filing: 20.01.2010
(51) Int. Cl.: H04R 1/38, H01L 29/84, H04R 1/02, H04R 19/04

(54) **MICROPHONE UNIT**

(30) Priority: 05.02.2009 JP 2009024439
(71) Applicant: Funai Electric Co., Ltd., Daito-shi Osaka 574-0013 (JP)
(72) Inventor: TANAKA Fuminori, Daito-shi Osaka 574-0013 (JP); HORIBE Ryusuke, Daito-shi Osaka 574-0013 (JP); INODA Takeshi, Daito-shi Osaka 574-0013 (JP)
(74) Representative: Manitz, Finsterwald & Partner GbR
(86) International application number: PCT/JP2010/050588
(87) International publication number: WO 2010/090070

(57) **Abstract**

Disclosed is a microphone unit (1) including: an electro-acoustic conversion section (13) that converts sound pressure to an electrical signal; a casing (11) that accommodates the electro-acoustic conversion section (13); and a cover (12) that covers the casing (11) and is provided with a first acoustic opening (121) and a second acoustic opening (122). The casing (11) consists of a laminated substrate comprising integrated laminated layers. The casing (11) is provided with: a concave space (111) in which the electro-acoustic conversion section (13) is mounted and which communicates with the first acoustic opening (121), and a hollow space (121) that provides communication between a bottom face (111a) of the concave space and the second acoustic opening (122). Thus, the microphone unit (1) is provided with a first acoustic path (2) from the first acoustic opening (121) through the concave space (111) to a first face (132a) of a diaphragm (132), and a second acoustic path (3) from the second acoustic opening (122) through the hollow space (111) to a second face (132b) of the diaphragm (132).

## Description

### Technical Field

The present invention relates to a microphone unit that converts a sound pressure (generated by, for example, voice) into an electric signal.

### Background Art

Conventionally, microphone units are applied to voice input devices, examples of which include voice communication equipment such as a mobile telephone and a transceiver, information processing systems utilizing a technology of analyzing input voice such as a voice authentication system, and recording equipment. In recent years, with the miniaturization of electronic equipment advancing, microphone units capable of, for example, being reduced in size and thickness have been actively developed (see, for example, Patent Documents 1 to 3).

Meanwhile, for the purposes of conversation via a telephone and the like, voice recognition, and voice recording, it is preferable that only a target sound (user's voice) be picked up. To this end, microphone units are desired to have the capabilities of accurately extracting a target sound and of removing noise (background noise and the like) other than the target sound.

As a microphone unit that picks up only a target sound by removing noise in a use environment where the noise is present, the applicant of the present invention has developed a microphone unit that is so built that sound pressures are applied from both faces of a diaphragm and in which an electric signal is generated by vibrations of the diaphragm based on a difference between the sound pressures (see Patent Document 3).

### List of Citations

### Patent Literature

Patent Document 1: JP-A-2007-150507
Patent Document 2: JP-A-2004-200766
Patent Document 3: JP-A-2008-258904

### Summary of the Invention

### Technical Problem

In pursuit of further development (improvement) of microphone units such as the one disclosed in Patent Document 3, it has been found, however, that an increase in the number of components forming sound paths is likely to lead to the occurrence of acoustic leakage, resulting in a deterioration in the quality of a microphone unit. Furthermore, such an increase in the number of components is unfavorable also from the viewpoint of workability, which has been another reason why a microphone unit is desired to be built using a reduced number of components.

With the foregoing in mind, it is an object of the present invention to provide a high-quality microphone unit that can be easily produced.

### Solution to the Problem

In order to achieve the above-described object, a microphone unit of the present invention includes: an electroacoustic conversion portion that has a diaphragm, which vibrates in response to a sound pressure, so as to convert the sound pressure into an electric signal; a casing that houses the electroacoustic conversion portion; and a lid that has a first sound opening and a second sound opening and is fitted over the casing. The casing is made of a lamination substrate formed by lamination and integration. The casing includes: a concave space in which the electroacoustic conversion portion is placed and that communicates with the first sound opening; and a hollow space that provides communication between a bottom surface of the concave space and the second sound opening. In the microphone unit, there are provided: a first sound path extending from the first sound opening to a first face of the diaphragm via the concave space; and a second sound path extending from the second sound opening to a second face of the diaphragm that is a rear side of the first face via the hollow space.

According to this configuration, the microphone unit is so configured as to convert, based on a difference between sound pressures applied to both the faces of the diaphragm, a sound pressure into an electric signal and is capable of picking up only a target sound by removing noise in a use environment where the noise is present. Furthermore, the casing that houses the electroacoustic conversion portion having the diaphragm and in which the first sound path and the second sound path are formed is formed integrally using a lamination substrate. This can reduce the number of components constituting the microphone unit, thereby allowing the occurrence of acoustic leakage to be reduced. Thus, according to the microphone unit having this configuration, high-quality microphone characteristics can be obtained. Furthermore, the above-described reduction in the number of components facilitates the production of the microphone unit and further can suppress production cost.

In the microphone unit having the above-described configuration, preferably, as the lamination substrate, an LTCC (low temperature co-fired ceramic) substrate is used. This configuration makes it more appropriate to select a low-resistance material such as, for example, Ag or Cu as a conductor used for a wiring pattern provided on the casing. This configuration also makes it easier to decrease a difference in linear expansion coefficient between the electroacoustic conversion portion and the casing. Decreasing a difference in linear expansion coefficient between them can reduce undesired stress applied to the diaphragm in a case where the electroacoustic conversion portion is mounted by reflowing.

In the microphone unit having the above-described configuration, the lamination substrate may be set to have a linear expansion coefficient of not less than 3 ppm/°C and not more than 5 ppm/°C. For example, in a case where the electroacoustic conversion portion is a MEMS chip made of silicon, the above-described configuration allows a difference in linear expansion coefficient between the electroacoustic conversion portion and the casing to be decreased.

In the microphone unit having the above-described configuration, preferably, the electroacoustic conversion portion is a MEMS (micro-electro-mechanical system) chip. This configuration makes it easier to provide a compact microphone with high characteristics.

In the microphone unit having the above-described configuration, a positioning wall for performing positioning of the electroacoustic conversion portion may be provided in the casing. This configuration facilitates positioning of the electroacoustic conversion portion when the electroacoustic conversion portion is mounted in the casing, thereby facilitating the production of the microphone unit.

In the microphone unit having the above-described configuration, an electric circuit portion that processes an electric signal obtained by the electoacoustic conversion portion may further be provided and placed in the concave space. Furthermore, in the microphone unit having the above-described configuration, the casing and the lid may be formed integrally with each other.

### Advantageous Effects of the Invention

The present invention can provide a high-quality microphone unit that can be easily produced.

### Brief Description of Drawings

[Fig. 1] A schematic perspective view showing a configuration of a microphone unit of an embodiment of the present invention.
[Fig. 2] A schematic cross-sectional view taken along a position A-A in Fig. 1.
[Fig. 3] A schematic plan view, as seen from above, of the microphone unit of the embodiment without a lid.
[Fig. 4] A schematic cross-sectional view for illustrating a production example of a casing included in the microphone unit of the embodiment.
[Fig. 5A] A top view of a first sheet constituting the casing included in the microphone unit of the embodiment.
[Fig. 5B] A top view of a second sheet constituting the casing included in the microphone unit of the embodiment.
[Fig. 5C] A top view of a third sheet constituting the casing included in the microphone unit of the embodiment.
[Fig. 5D] A top view of a fourth sheet constituting the casing included in the microphone unit of the embodiment.
[Fig. 6] A schematic cross-sectional view showing a configuration of a MEMS chip included in the microphone unit of the embodiment.
[Fig. 7] A diagram for illustrating a circuit configuration of an ASIC included in the microphone unit of the embodiment.
[Fig. 8] A diagram showing a modification example of the microphone unit of the embodiment.
[Fig. 9] An exploded perspective view showing a configuration of a microphone unit developed by the inventors of the present invention before developing the microphone unit of the present invention.
[Fig. 10] A schematic cross-sectional view of the microphone unit shown in Fig. 9 in an assembled state.

### Description of Embodiments

Hereinafter, an embodiment of a microphone unit to which the present invention is applied will be described in detail with reference to the appended drawings. Before that, however, for easier understanding of the present invention, the following describes a background behind the development of the microphone unit of the present invention.

### (Background behind Development of Present Invention)

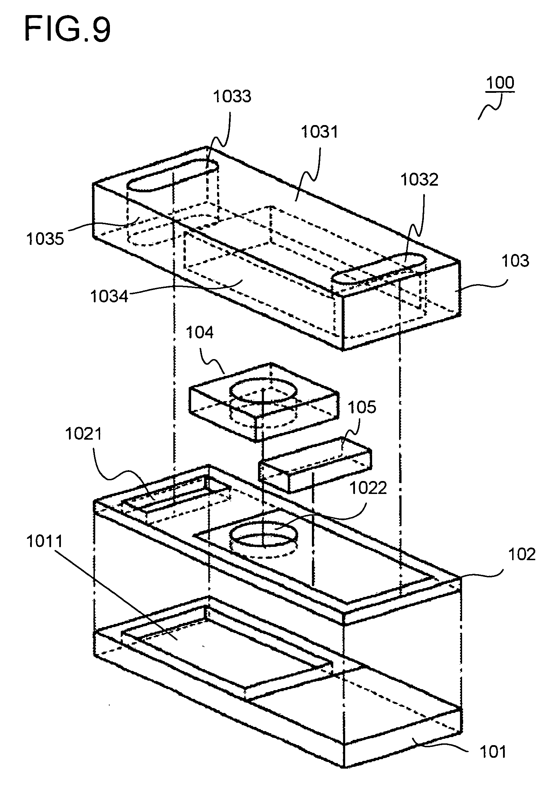

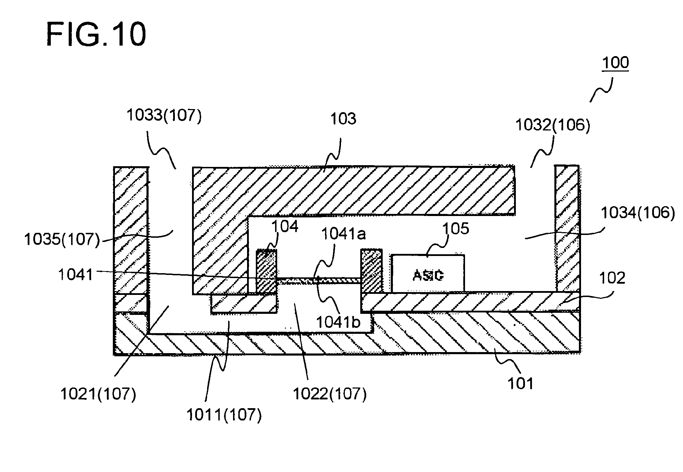

Fig. 9 is an exploded perspective view showing a configuration of a microphone unit developed by the inventors of the present invention before developing the microphone unit of the present invention. Furthermore, Fig. 10 is a schematic cross-sectional view of the microphone unit shown in Fig. 9 in an assembled state. In the following description, the microphone unit shown in Figs. 9 and 10 is denoted as a "priorly developed microphone unit 100".

As shown in Figs. 9 and 10, the priorly developed microphone unit 100 includes a first substrate 101, a second substrate 102 on which a MEMS (micro-electro-mechanical system) chip 104 and an ASIC (application specific integrated circuit) 105 are mounted, and a lid portion 103 disposed over the second substrate 102 so as to cover the MEMS chip 104 and the ASIC 105.

In the first substrate 101, a groove portion 1011 is formed in substantially a rectangular shape in a plan view.

In the second substrate 102 on which the MEMS chip 104 and the ASIC 105 are mounted and an unshown circuit pattern is formed, a first hole 1021 and a second hole 1022 are formed.

The lid portion 103 has an outer shape that is substantially rectangular in a plan view, and in a top plate 1031 thereof, two sound openings 1032 and 1033 that are substantially oval in a plan view are formed. On the inner side of the lid portion 103, a first space portion 1034 communicating with the first sound opening 1032 and a second space portion 1035 communicating with the second sound opening 1033 are formed.

The priorly developed microphone unit 100 is obtained by, for example, joining the second substrate 102 on which the MEMS chip 104 and the ASIC 105 are mounted to the first substrate 101 and subsequently joining together the lid portion 103 and the second substrate 102 in a state where the lid portion 103 is disposed so as to be fitted over the second substrate 102.

An electrode terminal (not shown) provided on the first substrate 101 and an electrode terminal (not shown) formed on the rear surface side of the second substrate 102 are electrically joined together, for example, by soldering or by use of a conductive paste. The circuit pattern formed on the upper surface side of the second substrate 102 and a circuit pattern formed on the rear surface side thereof are electrically connected to each other via through wiring (not shown) penetrating the second substrate 102.

With the above-described configuration, a first sound path 106 is formed that is made up of the first sound opening 1032 and the first space portion 1034 and guides sound waves to an upper face 1041a of a diaphragm 1041 of the MEMS chip 104. Furthermore, a second sound path 107 is formed that is made up of the second sound opening 1033, the second space portion 1035, the first hole 1021, the groove portion 1011, and the second hole 1022 and guides sound waves to a lower face 1041b of the diaphragm 1041 of the MEMS chip 104. This provides a configuration in which sound pressures are applied from both the faces of the diaphragm 104, and thus a microphone unit can be provided that picks up only a target sound by removing noise in a use environment where the noise is present.

Meanwhile, the priorly developed microphone unit 100 has been disadvantageous in that its microphone characteristics (acoustic characteristics) are not up to a satisfactory level. Our vigorous study on this has found that, due to reasons such as accuracy of processing the first substrate 101, the second substrate 102, and the lid portion 103, these components can hardly be tightly assembled together, so that acoustic leakage is likely to occur. It has also been found that such acoustic leakage leads to a deterioration in the acoustic characteristics of the microphone unit 100. The microphone unit of the present invention is intended to solve this problem.

### (Microphone Unit of Embodiment of Present Invention)

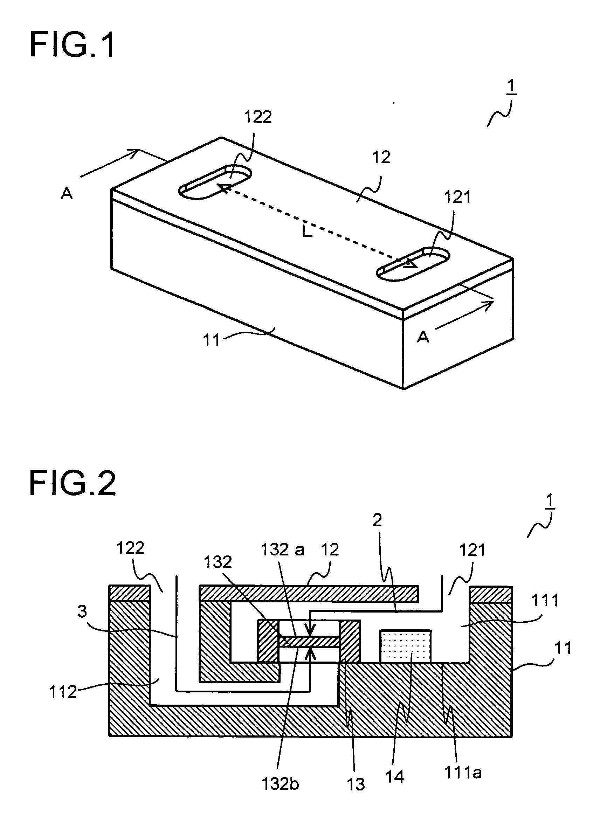

The following describes a schematic configuration of the microphone unit of the embodiment of the present invention with reference to Figs. 1 to 7.

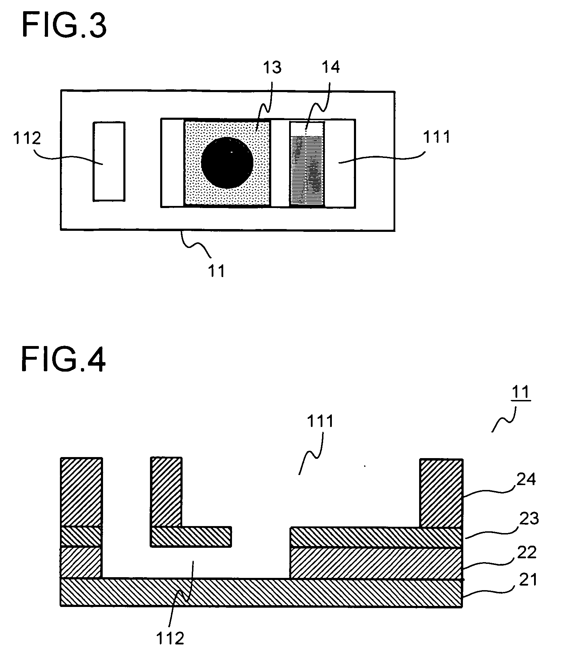

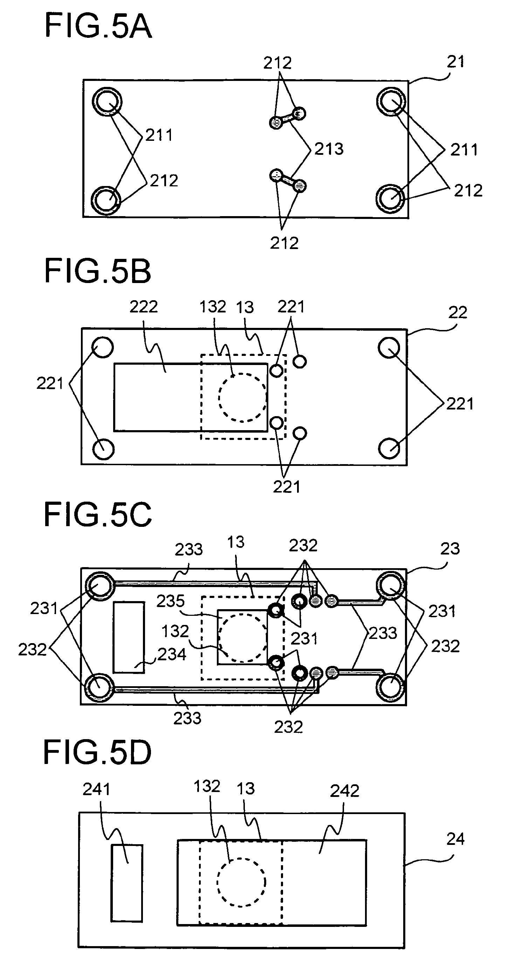

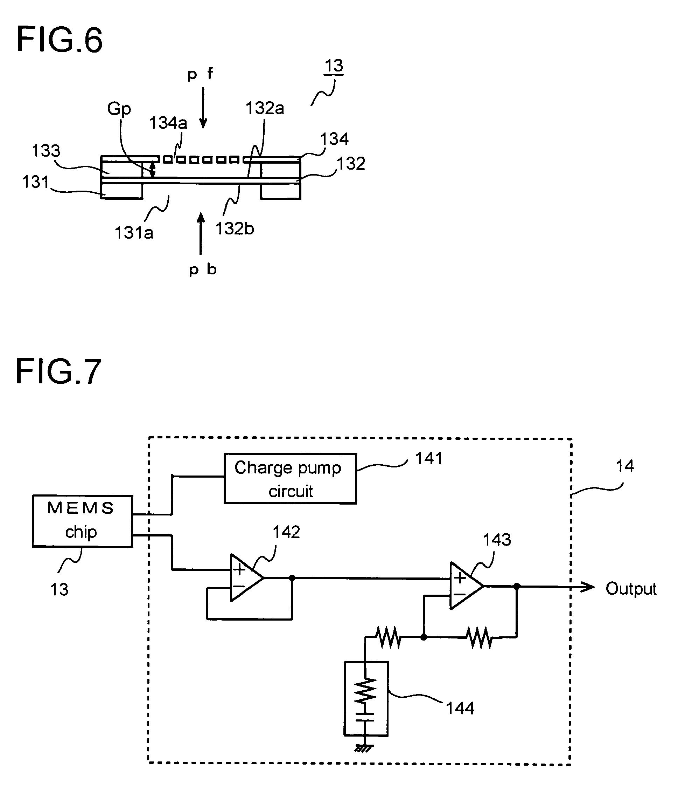

Fig. 1 is a schematic perspective view showing the configuration of the microphone unit of this embodiment. Fig. 2 is a schematic cross-sectional view taken along a position A-A in Fig. 1. Fig. 3 is a schematic plan view, as seen from above, of the microphone unit of this embodiment without a lid. Fig. 4 is a schematic cross-sectional view for illustrating a production example of a casing included in the microphone unit of this embodiment. Figs. 5A, 5B, 5C, and 5D are schematic plan views for illustrating the production example of the casing included in the microphone unit of this embodiment. Fig. 6 is a schematic cross-sectional view showing a configuration of a MEMS chip included in the microphone unit of this embodiment. Fig. 7 is a diagram for illustrating a circuit configuration of an ASIC included in the microphone unit of this embodiment.

As shown in Figs. 1 to 3, a microphone unit 1 of this embodiment includes a casing 11, a lid 12, a MEMS chip 13, and an ASIC 14.

The casing 11 has an outer shape of substantially a rectangular parallelepiped with an upper surface having a hole, and inside the casing 11, a space is formed so that the MEMS chip 13 and the ASIC 14 can be placed therein and so that sound waves can be guided to an upper face 132a and a lower face 132b of a diaphragm film (diaphragm) 132 of the MEMS chip 13.

To be more specific, in the casing 11, a concave space 111 is formed that is substantially rectangular when seen from above (see Figs. 2 and 3). The MEMS chip 13 and the ASIC 14 are placed in the concave space 111. Furthermore, in the casing 11, a hollow space 112 is formed that is made up of a space extending downward from a bottom surface 111a (surface on which the MEMS chip 13 and so on are placed) of the concave space 111 and a space that is substantially L-shaped in a cross-sectional view and links the above-described space to the upper surface (see Fig. 2).

The casing 11 is made of a lamination substrate formed by lamination and integration. In this embodiment, as the lamination substrate, an LTCC (low temperature co-fired ceramic) substrate is used. On the lamination substrate forming the casing 11, a wiring pattern required for operating the microphone unit 1 is also formed.

Now, referring to Figs. 4, 5A, 5B, 5C, and 5D, the following describes a production example of the casing 11 made of the lamination substrate. As shown in Fig. 4, the casing 11 included in the microphone unit 1 is formed by laminating a first sheet (referred to also as a green sheet) 21, a second sheet 22, a third sheet 23, and a fourth sheet 24, which are substantially the same in external dimensions, one over another in this order and integrating a resulting laminate. The laminate is integrated by, for example, being fired at about 800°C to 900°C. Before being laminated, the sheets 21 to 24 are subjected to punching and pattern printing so that a resulting integrated laminate of these sheets have the concave space 111, the hollow space 112, and the wiring pattern.

Figs. 5A, 5B, 5C, and 5D show holes formed in the sheets 21 to 24 and wiring formed thereon. Fig. 5A shows an upper surface of the first sheet 21, and Fig. 5B shows an upper surface of the second sheet 22. Fig. 5C shows an upper surface of the third sheet 23, and Fig. 5D shows an upper surface of the fourth sheet 24. In each of Figs. 5B, 5C, and 5D, the MEMS chip 13 and the diaphragm film 132 that are placed in the casing 11 are shown by dashed lines for clearer understanding of a positional relationship between them.

As shown in Fig. 5A, the first sheet 21 is provided with through holes 211, electrode pads 212, and wiring 213. The through holes 211 are intended to provide via connection between the electrode pads 212 formed on upper and lower surfaces of the first sheet 21, respectively (the electrode pads formed on the lower surface of the first sheet 21 are not shown). The electrode pads 212 and the wiring 213 are intended to enable connection between the MESM chip 13 and the ASIC 14, power supply to the ASIC 14, electric signal output from the ASIC 14, and ground connection.

As shown in Fig. 5B, the second sheet 22 is provided with through holes 221 and a through opening 222 that is substantially rectangular in a plan view. The through holes 221 are intended to form three-dimensional circuitry. Furthermore, the through opening 222 is intended to form the hollow space 112.

As shown in Fig. 5C, the third sheet 23 is provided with through holes 231, electrode pads 232, wiring 233, and through openings 234 and 235 that are substantially rectangular in a plan view. The through holes 231 are intended to form the three-dimensional circuitry. The electrode pads 232 are intended to establish connection with electrode pads formed on the MEMS chip 13 and the ASIC 14, respectively, and to form the three-dimensional circuitry. The through openings 234 and 235 are intended to form the hollow space 112.

As shown in Fig. 5D, the fourth sheet 24 is provided with through openings 241 and 242 that are substantially rectangular in a plan view. Of these openings, the through opening 241 is intended to form the hollow space 112, and the through opening 242 is intended to form the concave space 111.

It is preferable that the lamination substrate formed by laminating and integrating the four sheets 21 to 24 be so designed as to have a linear expansion coefficient as approximate as possible to a linear expansion coefficient of the MEMS chip 13. This is because, for example, in a case of mounting the MEMS chip 13 by reflowing, if there is a large difference in linear expansion coefficient between the lamination substrate and the MEMS chip 13, it is likely that heating and cooling performed at the time of the reflowing unfavorably results in applying residual stress to the MEMS chip 13, and the above-described design reduces such residual stress applied to the MEMS chip 13. In this embodiment, the MEMS chip 13 is made of silicon, and it is therefore preferable that the lamination substrate be set to have a linear expansion coefficient of not less than 3 ppm/°C and not more than 5 ppm/°C.

Furthermore, it is preferable that the electrode pads and wiring formed on the sheets 21 to 24 be made of a low-resistance conductor such as silver (Ag) or copper (Cu).

As shown in Figs. 1 and 2, the lid 12 is a flat plate that is substantially rectangular in a plan view, and two through openings 121 and 122 each penetrating between an upper surface and a lower surface of the lid 12 are formed therein. Although there is no particular limitation on a material of the lid 12, in this embodiment, for example, a metal, ceramic, or the like is used as the material. Furthermore, it is set that, in a state where the lid 12 is fitted over the casing 11, the first through opening 121 communicates with the concave space 111 of the casing 11, and the second through opening 122 communicates with the hollow space 112 of the casing 11.

The two through openings 121 and 122 are provided as sound openings, and in the following description, one of them is denoted as a first sound opening 121, while the other is denoted as a second sound opening. In this embodiment, the first sound opening 121 and the second sound opening 122 are elongated substantially oval openings. The shape thereof, however, is not limited thereto and may be changed as appropriate.

If an intercentral distance L (see Fig. 1) between the first sound opening 121 and the second sound opening 122 is too short, a difference between a sound pressure applied to the upper face 132a of the diaphragm film 132 and a sound pressure applied to the lower face 132b thereof becomes small to cause a decrease in the amplitude of the diaphragm film 132, resulting in a deterioration in the SNR (signal-to-noise ratio) of an electric signal outputted from the ASIC 14. Because of this, it is preferable that the distance between the first sound opening 121 and the second sound opening 122 be somewhat large. On the other hand, if the intercentral distance L is too large, a difference between a length of time required for sound waves emitted from a sound source to reach the diaphragm film 132 through the first sound opening 121 and a length of time required for sound waves emitted therefrom to reach the diaphragm film 132 through the second sound opening 122, namely, a phase difference becomes large to cause a deterioration in noise removing capability. Because of this, the intercentral distance L between the first sound opening 121 and the second sound opening 122 is preferably not less than 4 mm and not more than 6 mm and is more preferably about 5 mm.

Referring to Fig. 6, the following describes a configuration of the MEMS chip 13 placed in the concave space 111 of the casing 11. The MEMS chip 13 has an insulating base board 131, the diaphragm film 132, an insulating film 133, and a fixed electrode 134 and constitutes a capacitor type microphone. The MEMS chip 13 is produced using the semiconductor production technique and, in this embodiment, is made of silicon. The MEMS chip 13 represents an embodiment of the electroacoustic conversion portion of the present invention.

In the base board 131, a hole 131a that is substantially circular in a plan view is formed so as to allow sound waves coming from the lower side of the diaphragm film 132 to reach the diaphragm film 132. The diaphragm film 132 formed on the base board 131 is a thin film that vibrates (vertically vibrates) upon receiving sound waves, has conductivity, and forms one end of an electrode.

The fixed electrode 134 is disposed opposite to the diaphragm film 132 via the insulating film 133. The diaphragm film 132 and the fixed electrode 134 thus form a capacitor. In the fixed electrode 134, a plurality of sound openings 134a through which sound waves can pass are formed so as to allow sound waves coming from the upper side of the diaphragm film 132 to reach the diaphragm film 132.

Thus, the MEMS chip 13 is so configured that a sound pressure pf is applied to the upper face 132a of the diaphragm film 132 and a sound pressure pb is applied to the lower face 132b of the diaphragm film 132. As a result, the diaphragm film 132 vibrates depending on a difference between the sound pressure pf and the sound pressure pb to cause a gap Gp between the diaphragm film 132 and the fixed electrode 134 to vary, thus causing variations in electrostatic capacitance between the diaphragm film 132 and the fixed electrode 134. That is, the MEMS chip 13 functioning as the capacitor type microphone allows incident sound waves to be retrieved in the form of an electric signal.

In this embodiment, the diaphragm film 132 is positioned below the level of the fixed electrode 134. They may, however, also be in an inverted positional relationship (relationship in which the diaphragm film is positioned above the level of the fixed electrode).

Referring to Fig. 7, the following describes the ASIC 14 placed in the concave space 111 of the casing 11. The ASIC 14 represents an embodiment of the electric circuit portion of the present invention and is an integrated circuit that amplifies, by operating a signal amplification circuit 143, an electric signal generated based on variations in electrostatic capacitance in the MEMS chip 13. In this embodiment, the ASIC 14 includes a charge pump circuit 141 and an operational amplifier 142 so that variations in electrostatic capacitance in the MEMS chip 13 can be precisely obtained. The ASIC 14 also includes a gain adjustment circuit 144 so that a gain of the signal amplification circuit 143 can be adjusted. An electric signal that has been amplified by the ASIC 14 is outputted to, for example, a sound processing portion of an unshown mounting substrate on which the microphone unit 1 is mounted and is processed therein.

The microphone unit 1 composed of the above-described components is completed by flip-chip mounting the MEMS chip 13 and the ASIC 14 in the casing 11 formed integrally using the lamination substrate and subsequently joining together the lid 12 and the casing 11 in a state where the lid 12 is fitted over the casing 11. The lid 12 may be joined to the casing 11 by use of, for example, an adhesive or may be swaged to the casing 11. Furthermore, the MEMS chip 13 and the ASIC 14 may be mounted also by, for example, wire bonding instead of being flip-chip mounted.

The MEMS chip 13 mounted in the casing 11 is disposed so as to cover a hole (referring to a hole for forming the hollow space 112) formed in the bottom surface 111a of the concave space 111. Consequently, as schematically shown by arrows in Fig. 2, there are formed a first sound path 2 extending from the first sound opening 121 to the upper face (first face) 132a of the diaphragm film 132 via the concave space 111 and a second sound path 3 extending from the second sound opening 122 to the lower face (second face) 132b of the diaphragm film 132 via the hollow space 112. It is preferable that the first sound path 2 and the second sound path 3 be so formed that a length of time required for sound waves to travel from the first sound opening 121 to the upper face 132a of the diaphragm film 132 is equal to a length of time required for sound waves to travel from the second sound opening 122 to the lower face 132b of the diaphragm film 132.

Next, a description is made of an operation of the microphone unit 1, which, however, is preceded by a description of the properties of sound waves. The sound pressure of sound waves (amplitude of sound waves) is inversely proportional to a distance from a sound source. At a position close to a sound source, the sound pressure is attenuated sharply, and the sharpness of the attenuation decreases with increasing distance from the sound source.

For example, in a case where the microphone unit 1 is applied to a close-talking type voice input device, a user's voice is generated in proximity to the microphone unit 1. Because of this, the user's voice is attenuated to a large extent between the first sound opening 121 and the second sound opening 122, so that there occurs a large difference between a sound pressure incident on the upper face 132a of the diaphragm film 132 and a sound pressure incident on the lower face 132b of the diaphragm film 132.

On the other hand, as for a noise component such as background noise, a sound source thereof is positioned far from the microphone unit 1 compared with a sound source of the user's voice. Because of this, the sound pressure of noise is hardly attenuated between the first sound opening 121 and the second sound opening 122, so that there hardly occurs a difference between a sound pressure incident on the upper face 132a of the diaphragm film 132 and a sound pressure incident on the lower face 132b of the diaphragm film 132.

The diaphragm film 132 of the microphone unit 1 vibrates based on a difference between sound pressures of sound waves that concurrently enter the first sound opening 121 and the second sound opening 122, respectively. A difference between a sound pressure of noise incident on the upper face 132a of the diaphragm film 132 and a sound pressure of the noise incident on the lower face 132b thereof is extremely small as described above and thus is cancelled by the diaphragm film 132. In contrast, a difference between a sound pressure of a user's voice incident on the upper face 132a of the diaphragm film 132 and a sound pressure of the user's voice incident on the lower face 132b thereof is large and thus causes the diaphragm film 132 to vibrate without being cancelled by the diaphragm film 132.

Judging from the above, according to the microphone unit 1 of this embodiment, it can be considered that the diaphragm film 132 vibrates in response only to a user's voice. It can therefore be considered that an electric signal outputted from the ASIC 14 of the microphone unit 1 is a signal representing only the user's voice from which noise (background noise and the like) has been removed. That is, according to the microphone unit 1 of this embodiment, an electric signal representing only a user's voice from which noise has been removed can be obtained using a simple configuration.

Furthermore, the microphone unit 1 has a configuration in which the casing 11 is made of the lamination substrate formed by lamination and integration. Hence, compared with the priorly developed microphone unit 100 (see Figs. 9 and 10), the likelihood of the occurrence of acoustic leakage is reduced, and thus high-quality microphone characteristics can be obtained. Furthermore, the number of components constituting the casing 11 is reduced, and thus not only a reduction in material cost but also simplification of a production process and a reduction in production cost can be achieved.

Furthermore, the casing 11 has an integrated laminate structure further including the second sound path 3, and thus the mechanical strength of the casing 11 can be increased. This therefore also allows a thickness reduction of part or all of the plurality of sheets 21 to 24 (see Fig. 4) constituting the casing 11. As a result, a thickness reduction of the microphone unit 1 can be achieved.

### (Modifications and Variations)

The foregoing embodiment is only illustrative, and the microphone unit of the present invention is not limited to the configuration of the foregoing embodiment. That is, the configuration of the foregoing embodiment may be variously modified without departing from the spirit of the present invention.

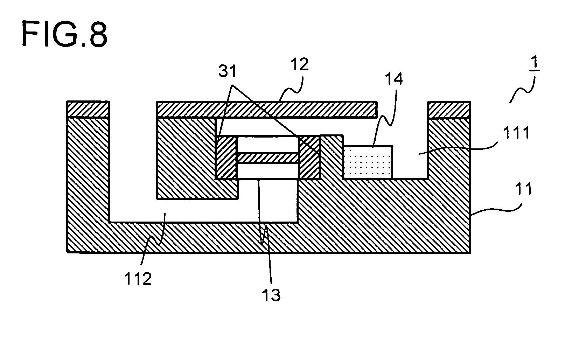

An example of possible modifications is shown in Fig. 8. That is, in a microphone unit shown in Fig. 8, with respect to a MEMS chip 13 formed in the shape of substantially a rectangular parallelepiped, positioning walls 31 that come in contact with outer surfaces of the MEMS chip 13 are provided so as to surround the outer surfaces of the MEMS chip 13. The positioning walls 31 are formed integrally with a casing 11. This configuration facilitates positioning of the MEMS chip 13 when the MEMS chip 13 is mounted in the casing 11, thereby further facilitating the production of a microphone unit.

Furthermore, in the foregoing embodiment, the casing 11 and the lid 12 are components independent of each other. There is, however, no limitation thereto, and a configuration is also possible in which the lid is also made of a lamination substrate and the casing and the lid are formed integrally with each other.

Furthermore, in the foregoing embodiment, as the lamination substrate (formed by lamination and integration) forming the casing 11, an LTCC substrate is used. This configuration, however, should not be construed as limiting, and as the lamination substrate forming the casing, for example, an alumina substrate, a glass epoxy substrate, or the like may also be used. In a case, however, where an LTCC substrate is used as the lamination substrate forming the casing, a low-resistance conductor (Ag, Cu, or the like) can be used as a conductor for forming the wiring pattern. Furthermore, the use of an LTCC substrate makes the casing 11 likely to have a linear expansion coefficient approximate to a linear expansion coefficient of the MEMS chip 13 made of silicon. By decreasing a difference in linear expansion coefficient between the casing 11 and the MEMS chip 13 in this manner, residual stress applied to the MEMS chip 13 as a result of heating and cooling performed at the time of reflowing can be reduced, and thus the likelihood that undesired stress is applied to the diaphragm film 132 can be reduced. From viewpoints including the above, it is preferable that, as in the embodiment of the present invention, an LTCC substrate be used as the lamination substrate forming the casing 11.

Furthermore, in the foregoing embodiment, the MEMS chip 13 and the ASIC 14 are chips independent of each other. A configuration, however, is also possible in which the integrated circuit included in the ASIC 14 is monolithically formed on the silicon board constituting the MEMS chip 13.

Furthermore, the foregoing embodiment has a configuration in which the acoustoelectric conversion portion that converts a sound pressure into an electric signal is represented by the MEMS chip 13 built utilizing the semiconductor production technique. This configuration, however, should not be construed as limiting. For example, the electroacoustic conversion portion may also be a capacitor microphone using an electret film.

Furthermore, in the foregoing embodiment, the electroacoustic conversion portion (corresponding to the MEMS chip 13 of the embodiment of the present invention) included in the microphone unit 1 has a configuration of a so-called capacitor type microphone. The present invention, however, can be applied also to microphone units adopting configurations other than the configuration of the capacitor type microphone. For example, the present invention can be applied to a microphone unit adopting a dynamic microphone, a magnetic microphone, or a piezoelectric microphone.

In addition to the above, the shape of the microphone unit used in the embodiment of the present invention should not be construed as limiting and, needless to say, can be variously changed.

### Industrial Applicability

The microphone unit of the present invention is favorably applicable to, for example, voice communication equipment such as a mobile telephone and a transceiver, voice processing systems adopting a technology of analyzing input voice (voice authentication system, voice recognition system, command generation system, electronic dictionary, translation machine, voice input type remote controller, and the like), recording equipment, amplifier systems (loudspeakers), or microphone systems.

### List of Reference Signs

- 1: Microphone unit
- 2: First sound path
- 3: Second sound path
- 11: Casing
- 12: Lid
- 13: MEMS chip (electroacoustic conversion portion)
- 14: ASIC (electric circuit portion)
- 31: Positioning wall
- 111: Concave space
- 111a: Bottom surface of concave space
- 112: Hollow space
- 121: First sound opening
- 122: Second sound opening
- 132: Diaphragm film (diaphragm)
- 132a: Upper face (first face) of diaphragm film
- 132b: Lower face (second face) of diaphragm film

## Claims

1. A microphone unit, comprising:
an electroacoustic conversion portion that has a diaphragm, which vibrates in response to a sound pressure, so as to convert the sound pressure into an electric signal;
a casing that houses the electroacoustic conversion portion; and
a lid that has a first sound opening and a second sound opening and is fitted over the casing,
wherein
the casing is made of a lamination substrate formed by lamination and integration,
the casing includes:
a concave space in which the electroacoustic conversion portion is placed and that communicates with the first sound opening; and
a hollow space that provides communication between a bottom surface of the concave space and the second sound opening, and
there are provided:
a first sound path extending from the first sound opening to a first face of the diaphragm via the concave space; and
a second sound path extending from the second sound opening to a second face of the diaphragm that is a rear side of the first face via the hollow space.

2. The microphone unit according to claim 1, wherein
as the lamination substrate, an LTCC (low temperature co-fired ceramic) substrate is used.

3. The microphone unit according to claim 1, wherein
the lamination substrate has a linear expansion coefficient of not less than 3 ppm/°C and not more than 5 ppm/°C.

4. The microphone unit according to claim 1, wherein
the electroacoustic conversion portion is a MEMS (micro-electro-mechanical system) chip.

5. The microphone unit according to claim 1, wherein
a positioning wall for performing positioning of the electroacoustic conversion portion is provided in the casing.

6. The microphone unit according to claim 1, further comprising:
an electric circuit portion that processes an electric signal obtained by the electoacoustic conversion portion,
wherein the electric circuit portion is placed in the concave space.

7. The microphone unit according to claim 1, wherein
the casing and the lid are formed integrally with each other
